# EUROPEAN PATENT APPLICATION

(11) **EP 4 644 764 A1**
(43) Date of publication of application: **05.11.2025**
(21) Application number: 24870567.5
(22) Date of filing: 19.09.2024
(51) Int. Cl.: F21K 9/20

(54) **LED LIGHT SOURCE MODULE**

(30) Priority: 28.09.2023 CN 202322682299 U
(71) Applicant: Godox Photo Equipment Co., Ltd., Shenzhen, Guangdong 518000 (CN)
(72) Inventor: ZENG, Weijun, Shenzhen, Guangdong 518000 (CN)
(74) Representative: Studio Torta S.p.A.
(86) International application number: PCT/CN2024/119778
(87) International publication number: WO 2025/067023

(57) **Abstract**

An LED light source module (100), comprising a substrate (10) and light mixing chip groups (20), wherein a first light emitting area (101) and a second light emitting area (102) are symmetrically arranged on the surface of the substrate (10) with respect to a reference axis (11), the plurality of light mixing chip groups (20) are arranged in the first light emitting area (101) and the second light emitting area (102) in an array, chips arranged in the light mixing chip groups (20) in the first light emitting area (101) and chips arranged in the light mixing chip groups (20) in the second light emitting area (102) are symmetrically arranged with respect to the reference axis (11), two adjacent columns of light mixing chip groups (20) are arranged in offset positions, and two adjacent rows of light mixing chip groups (20) are arranged in offset positions. In this way, red light chips (21), green light chips (22) and blue light chips (23) in the light mixing chip groups (20) can be uniformly arranged on the substrate (10), such that the light mixing effect of the light mixing chip groups (20) is better, more uniform light emission is achieved, the compact configuration of the red light chips (21), the green light chips (22) and the blue light chips (23) on the substrate (10) can be ensured to reduce the area of the substrate (10), and the miniaturization design of a filming and photographing lamp can be further facilitated while the uniform light mixing and light emitting requirements of the filming and photographing lamp are satisfied.

## Description

### CROSS-REFERENCE TO RELATED APPLICATIONS

The present application claims priority to Chinese Patent Application No. 202322682299.0, titled "LED Light Source Module", filed on September 28, 2023, the entire disclosure of which is hereby incorporated herein by reference.

### TECHNICAL FIELD

The present application relates to the technical field of light-emitting devices, particularly to a Light-Emitting Diode (LED) light source module.

### BACKGROUND

In current photography and video shooting scenarios, in order to achieve better imaging effects, people often use Light-Emitting Diode (LED) photography and video lights as auxiliary light sources for photography and video shooting.

To adjust the luminous color of the light source, LED photography and video lights typically have a plurality of light-emitting chips of different colors (such as RGB) mounted on their substrates. However, when a plurality of light-emitting chips of different colors illuminate onto the substrate, the arrangement of these chips easily causes uneven luminous color,for example, one region appears bluish while another region appears reddish.

Since photography and video lights have high requirements for luminous color uniformity, how to arrange a plurality of light-emitting chips of different colors to improve the color uniformity of the light has become a major issue in the industry. Meanwhile, to address the problem of luminous uniformity, existing LED light-emitting chips often adopt various rotational placement methods. However, such arrangements usually result in gaps between the light-emitting chips, which increases the area of the light-emitting substrate and is not conducive to product miniaturization.

### SUMMARY

The purpose of the present application is to solve the technical problem in the related art that, in order to balance the high requirement for luminous uniformity of photography and video lights, the LED light-emitting chips adopt various rotational placement methods, resulting in certain gaps between the light-emitting chips, which increases the area of the light-emitting substrate and is not conducive to product miniaturization.

To solve the above technical problem, the present application provides a Light-Emitting Diode (LED) light source module, which includes:
a circular substrate, wherein any one diameter of the substrate is a reference axis, and a surface of the substrate is provided with a first light-emitting region and a second light-emitting region symmetrically about the reference axis;
a plurality of light-mixing chip groups, provided in an array in the first light-emitting region and the second light-emitting region;
wherein each light-mixing chip group includes a red light chip, a green light chip, and a blue light chip, and chips in light-mixing chip groups provided in the first light-emitting region and chips in light-mixing chip groups provided in the second light-emitting region are symmetrical about the reference axis, and light-mixing chip groups in adjacent columns and adjacent rows are provided in a staggered manner.

In one embodiment, chips in each light-mixing chip group are sequentially provided along a length direction of each light-mixing chip group.

In one embodiment, the length direction of each light-mixing chip group is perpendicular to an extension direction of the reference axis.

In one embodiment, the plurality of the light-mixing chip groups are provided at intervals on the reference axis, and light-mixing chip groups provided on the reference axis are on-axis chip groups; and
types of chips in on-axis chip groups close to the first light-emitting region are different from that of the chips in the light-mixing chip groups provided in the first light-emitting region close to the reference axis.

In one embodiment, types of chips in on-axis chip groups close to the second light-emitting region are different from those of the chips in the light-mixing chip groups provided in the second light-emitting region close to the reference axis.

In one embodiment, the plurality of the light-mixing chip groups provided on the substrate form several light-mixing units; and
each light-mixing unit includes four adjacent light-mixing chip groups, and centers of the four light-mixing chip groups are connected to form a rhombus.

In one embodiment, a region surrounded by the four light-mixing chip groups in each light-mixing unit is an installation region, the LED light source module further comprises a plurality of warm-cool chip groups provided on the substrate, and each warm-cool chip group comprises a warm light chip and a cool light chip;
the plurality of warm-cool chip groups are provided in the installation region and outside each light-mixing chip group.

In one embodiment, each warm-cool chip groups provided in the installation region includes two warm light chips and two cool light chips, and the two warm light chips and the two cool light chips are provided in a staggered manner or adjacent manner.

In one embodiment, the plurality of the warm-cool chip groups located in the installation region on the substrate form several warm-cool units, and each warm-cool unit comprises four adjacent warm-cool chip groups.

In one embodiment, centers of the four warm-cool chip groups are connected to form a rhombus.

In one embodiment, a diameter of the substrate perpendicular to the reference axis is a datum axis, and the plurality of light-mixing chip groups on both sides of the reference axis are symmetrically about the datum axis.

In one embodiment, the plurality of the warm-cool chip groups are provided in an array on the substrate, and warm light chips and cool light chips in a plurality of warm-cool chip groups in each row are symmetrically and alternately provided on both sides of the datum axis.

In one embodiment, two sides of the datum axis are a first side and a second side;
in the plurality of warm-cool chip groups in the same row, types of chips in warm-cool chip groups provided on the first side of the datum axis in the same row are the same, and types of chips in warm-cool chip groups provided on the second side of the datum axis in the same row are opposite to those in the warm-cool chip groups provided on the first side of the reference axis in the same row.

In one embodiment, in an extension direction of the reference axis and a direction parallel to the reference axis, the plurality of warm-cool chip groups and the plurality of light-mixing chip groups on the substrate are alternately provided in sequence.

In one embodiment, in the extension direction of the datum axis and the direction parallel to the datum axis, the plurality of warm-cool chip groups and the plurality of light-mixing chip groups on the substrate are alternately provided in sequence.

The technical solution shows that the present application has the following beneficial effects: the LED light source module of the present application includes a substrate and a light-mixing chip group. The surface of the substrate is provided with a first light-emitting region and a second light-emitting region symmetrically about a reference axis. A plurality of light-mixing chip groups are provided in an array in the first and second light-emitting regions. The chips in the light-mixing chip groups provided in the first light-emitting region and the chips in the light-mixing chip groups provided in the second light-emitting region are symmetrical about the reference axis. The light-mixing chip groups in adjacent columns and adjacent rows are provided in a staggered manner. This arrangement enables the red, green, and blue chips in the light-mixing chip groups to be evenly distributed on the substrate, so that the light mixing effect between the light-mixing chip groups is better and the luminous uniformity is improved, and it ensures the compact arrangement of the red, green, and blue chips on the substrate to reduce the area of the substrate. While meeting the requirement of uniform light mixing for photography and video lights, it is also conducive to miniaturization of photography and video lights.

### BRIEF DESCRIPTION OF THE DRAWINGS

FIG. 1 is a structural schematic view of an LED light source module of an embodiment of the present application.
FIG. 2 is a structural schematic view of an LED light source module of another embodiment of the present application.
FIG. 3 is a layout schematic view of a warm-cool chip group in the LED light source module shown in FIG. 2.

Reference numbers: 100: LED light source module; 10: Substrate; 101: First light-emitting region; 102: Second light-emitting region; 103: Installation region; 11: Reference axis; 12: Datum axis; 20: Light-mixing chip group; 201: Light-mixing unit; 2011: On-axis chip group; 21: Red light chip; 22: Green light chip; 23: Blue light chip; 30: Warm-cool chip group; 301: Warm-cool unit; 31: Warm light chip; 32: Cool light chip.

### DETAILED DESCRIPTION OF THE EMBODIMENTS

A typical embodiment demonstrating the features and advantages of the present application will be described in detail below. It should be understood that the present application is capable of various changes in different embodiments, all without departing from the scope of the present application, and the descriptions and drawings herein are essentially for illustrative purposes rather than to limit the present application.

In the description of the present application, it should be understood that in the embodiments shown in the drawings, indications of directions or positional relationships (such as up, down, left, right, front, and rear, etc.) are only for the convenience of describing the present application and simplifying the description, rather than indicating or implying that the referred device or element must have a specific orientation, be constructed, and operate in a specific orientation. When these elements are in the positions shown in the drawings, these descriptions are appropriate. If the description of the positions of these elements changes, the indications of these directions shall also change accordingly.

Furthermore, the terms "first" and "second" are only used for descriptive purposes and cannot be interpreted as indicating or implying relative importance or implicitly specifying the quantity of the indicated technical features. Thus, a feature defined with "first" or "second" may explicitly or implicitly include one or more of such features. In the description of this application, "a plurality of" means two or more, unless specifically and clearly defined otherwise.

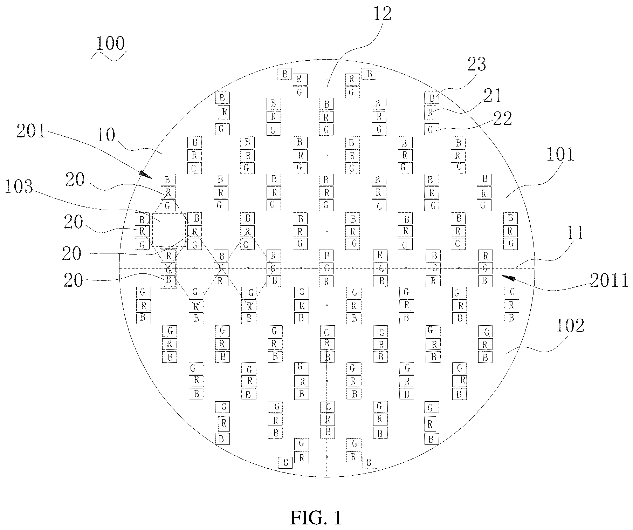

Referring to FIG. 1, an embodiment of the present application provides a Light-Emitting Diode (LED) light source module 100. By arranging and packaging different light-emitting chips in a certain manner and layout density to form light-mixing units, the different light-emitting chips can mix light, and the overall structure of the LED light source module 100 is compact, effectively reducing the area of the substrate 10, which is conducive to the miniaturization of photography and video lights.

The LED light source module 100 of this embodiment includes a substrate 10 and a light-mixing chip group 20. The substrate 10 is circular, any one diameter of the substrate 10 is a reference axis 11, and the surface of the substrate 10 is provided with a first light-emitting region 101 and a second light-emitting region 102 symmetrically about the reference axis 11.

There are a plurality of light-mixing chip groups 20, which are provided in an array in the first light-emitting region 101 and the second light-emitting region 102. Each light-mixing chip group 20 includes a red light chip 21 (marked as R), a green light chip 22 (marked as G), and a blue light chip 23 (marked as B). The chips in the light-mixing chip groups 20 provided in the first light-emitting region 101 and the chips in the light-mixing chip groups 20 provided in the second light-emitting region 102 are symmetrical about the reference axis 11. The light-mixing chip groups 20 in adjacent columns and adjacent rows are provided in a staggered manner.

In this embodiment, the substrate 10 is circular, and any one diameter of the substrate 10 can be selected as the reference axis 11. A diameter of the substrate 10 perpendicular to the reference axis 11 is a datum axis 12.

The reference axis 11 divides a surface of the substrate 10 into the first light-emitting region 101 and the second light-emitting region 102, which are symmetrical about the reference axis 11.

In this embodiment, each light-mixing chip group 20 includes one red light chip 21, one green light chip 22, and one blue light chip 23. The chips in the light-mixing chip group 20 are sequentially provided along an length direction of the light-mixing chip group 20, and the length direction of the light-mixing chip group 20 is perpendicular to an extension direction of the reference axis 11. The arrangement order of the red light chip 21, green light chip 22, and blue light chip 23 in each light-mixing chip group 20 is not limited, as long as the three chips are sequentially provided along the length direction of the light-mixing chip group 20 to form a linear strip structure.

The plurality of light-mixing chip groups 20 are provided on both the first light-emitting region 101 and the second light-emitting region 102 of the substrate 10, and the plurality of light-mixing chip groups 20 are provided in an array on the surface of the substrate 10. The length direction of each light-mixing chip group 20 is perpendicular to the extension direction of the reference axis 11.

In this embodiment, the chips in the light-mixing chip group 20 provided in the first light-emitting region 101 and the chips in the light-mixing chip group 20 provided in the second light-emitting region 102 are symmetrical about the reference axis 11. The light-mixing chip groups 20 in adjacent columns and adjacent rows are provided in a staggered manner.

This arrangement enables the red light chips 21, the green light chips 22, and the blue light chips 23 in the light-mixing chip groups 20 to be evenly provided on the substrate 10, so that the light mixing effect between the light-mixing chip groups 20 is better and the luminous uniformity is improved. Moreover, it ensures the compact arrangement of the red light chips 21,the green light chips 22, and the blue light chips 23 on the substrate 10 to reduce the area of the substrate 10. While meeting the requirement of uniform light mixing for photography and video lights, it is also conducive to the miniaturization of photography and video lights.

In this embodiment, a plurality of light-mixing chip groups 20 are provided at intervals on the reference axis 11 of the substrate 10, and the light-mixing chip groups 20 provided on the reference axis 11 are on-axis chip groups 2011.

The types of the chips in the on-axis chip groups 2011 close to the first light-emitting region 101 are different from those of the chips in the light-mixing chip groups 20 provided in the first light-emitting region 101 close to the reference axis 11. The types of the chips in the on-axis chip groups 2011 close to the second light-emitting region 102 are different from those of the chips in the light-mixing chip groups 20 provided in the second light-emitting region 102 close to the reference axis 11.

This arrangement can make the red light chips 21, the green light chips 22, and the blue light chips 23 provided on the substrate 10 more evenly distributed, thereby avoiding the same type of chips from overlapping for light mixing to affect the light mixing effect, ensuring the light mixing uniformity of the plurality of light-mixing chip groups 20, and the light-emitting effect.

Further, in this embodiment, a plurality of light-mixing chip groups 20 provided on the substrate 10 form several light-mixing units 201. Each light-mixing unit 201 includes four adjacent light-mixing chip groups 20, and centers of the four light-mixing chip groups 20 are connected to form a rhombus. A region surrounded by the four light-mixing chip groups 20 in each light-mixing unit 201 of this embodiment is an installation region 103. A plurality of installation regions 103 are provided at intervals on the substrate 10.

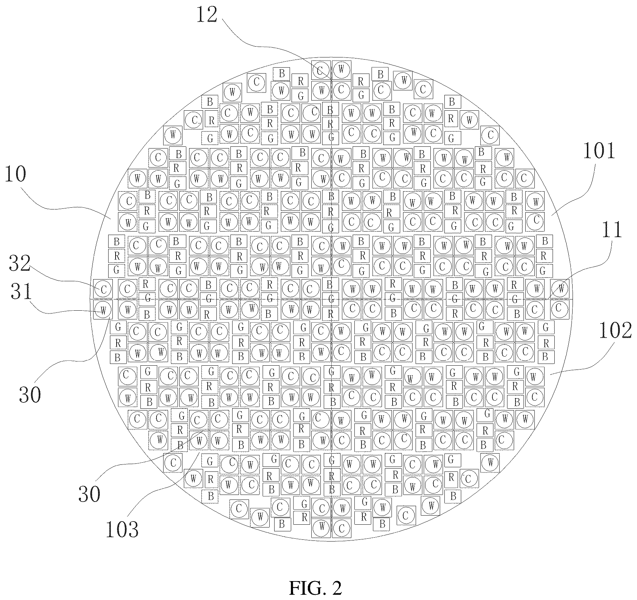

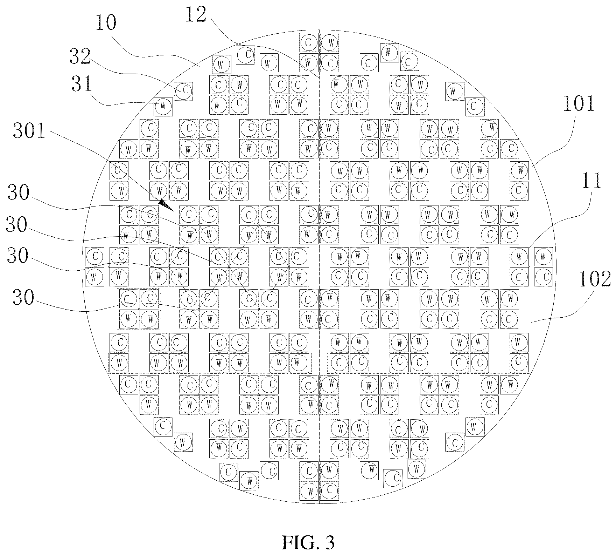

Combining FIG. 2 and FIG. 3, in another embodiment of the present application, the LED light source module 100 further includes a plurality of warm-cool chip groups 30 provided on the substrate 10. Each warm-cool chip group 30 includes adjacent warm light chips 31 (marked as W) and cool light chips 32 (marked as C). The warm-cool chip groups 30 are provided in the installation regions 103 and outside the light-mixing chip groups 20.

The warm-cool chip groups 30 are provided in the installation region 103 formed by each light-mixing unit 201. The red light chips 21, the green light chips 22, and the blue light chips 23 in each light-mixing chip group 20 in the light-mixing unit 201 can mix light with the warm light chips 31 and cool light chips 32 in the warm-cool chip groups 30, so that the white light synthesized by each light-mixing chip group 20 is superimposed with the warm-cool white light synthesized by its corresponding warm-cool chip group 30, making the light source color more uniform and improving the light mixing effect.

In this embodiment, the warm-cool chip groups 30 provided in the installation regions 103 each include two warm light chips 31 and two cool light chips 32, and the two warm light chips 31 and the two cool light chips 32 are provided in a staggered manner or adjacent manner. This arrangement can enhance the light mixing effect of the light-mixing chip groups 20 and the warm-cool chip groups 30, making the light effect of the LED light source module 100 better.

A plurality of warm-cool chip groups 30 located in the installation regions 103 on the substrate 10 of this embodiment form several warm-cool units 301. Each warm-cool unit 301 includes four adjacent warm-cool chip groups 30, and centers of the four warm-cool chip groups 30 are connected to form a rhombus.

This arrangement makes the warm-cool chip groups 30 and the light-mixing chip groups 20 provided in the installation regions 103 of the substrate 10 as a whole in an array on the substrate 10, so that the warm-cool chip groups 30 and the light-mixing chip groups 20 are more compactly provided on the substrate 10, effectively reducing the area of the substrate 10 and being more conducive to realizing the miniaturization of the LED light source module 100.

In the extension direction of the reference axis 11 and the direction parallel to the reference axis 11, the warm-cool chip groups 30 and the light-mixing chip groups 20 are alternately provided in sequence. In the extension direction of the datum axis 12 and the direction parallel to the datum axis 12, the warm-cool chip groups 30 and the light-mixing chip groups 20 are alternately provided in sequence.

In this embodiment, a plurality of warm-cool chip groups 30 are provided in an array on the substrate 10, and the warm light chips 31 and the cool light chips 32 in the plurality of warm-cool chip groups 30 in each row are symmetrically and alternately provided on both sides of the datum axis 12. This arrangement makes the warm light chips 31 and cool light chips 32 more evenly provided on the substrate 10, improving the light mixing and uniform light effect of the warm-cool chip groups 30 and the light-mixing chip groups 20.

In addition, in this embodiment, the chips in the light-mixing chip group 20 provided in the first light-emitting region 101 and the chips in the light-mixing chip group 20 provided in the second light-emitting region 102 are symmetrical about the reference axis 11. On both sides of the datum axis 12, the respective chips in the a plurality of light-mixing chip groups 20 are also symmetrical about the datum axis 12.

In this embodiment, a plurality of warm-cool chip groups 30 are provided in an array on the substrate 10, and the warm light chips 31 and cool light chips 32 in the plurality of warm-cool chip groups 30 in each row are symmetrically and alternately provided on both sides of the datum axis 12.

Specifically, the two sides of the datum axis 12 in this embodiment are a first side and a second side. In the plurality of warm-cool chip groups 30 in the same row, the types of chips in the warm-cool chip groups 30 provided on the first side of the datum axis 12 in the same row are the same, and the types of chips in the warm-cool chip groups 30 provided on the second side of the datum axis 12 in the same row are opposite to those in the warm-cool chip groups 30 provided on the first side of the datum axis 12 in the same row. This arrangement makes the warm light chips 31 and cool light chips 32 more evenly provided on the substrate 10, improving the light mixing and uniform light effect of the warm-cool chip groups 30 and the light-mixing chip groups 20.

The LED light source module of this embodiment includes a substrate and a light-mixing chip group. The surface of the substrate is provided with a first light-emitting region and a second light-emitting region symmetrically about a reference axis. A plurality of light-mixing chip groups are provided in an array in the first and second light-emitting regions. The chips in the light-mixing chip groups provided in the first light-emitting region and the chips in the light-mixing chip groups provided in the second light-emitting region are symmetrical about the reference axis. The light-mixing chip groups in adjacent columns and adjacent rows are provided in a staggered manner. This arrangement enables the red, green, and blue chips in the light-mixing chip groups to be evenly distributed on the substrate, so that the light mixing effect between the light-mixing chip groups is better and the luminous uniformity is improved, and it ensures the compact arrangement of the red, green, and blue chips on the substrate to reduce the area of the substrate. While meeting the requirement of uniform light mixing for photography and video lights, it is also conducive to miniaturization of photography and video lights.

Although the present application has been described with reference to several typical embodiments, it should be understood that the terms used are illustrative and exemplary rather than restrictive. Since the present application can be embodied in many forms without departing from the spirit or essence of the present application, it should be understood that the above embodiments are not limited to any of the foregoing details but should be widely interpreted within the spirit and scope defined by the appending claims. Therefore, all changes and modifications falling within the scope of the claims or their equivalents should be covered by the appending claims.

## Claims

1. A Light-Emitting Diode (LED) light source module, **characterized by** comprising:
a circular substrate, wherein any one diameter of the substrate is a reference axis, and a surface of the substrate is provided with a first light-emitting region and a second light-emitting region symmetrically about the reference axis;
a plurality of light-mixing chip groups, provided in an array in the first light-emitting region and the second light-emitting region;
wherein each light-mixing chip group comprises a red light chip, a green light chip, and a blue light chip, and chips in light-mixing chip groups provided in the first light-emitting region and chips in light-mixing chip groups provided in the second light-emitting region are symmetrical about the reference axis, and light-mixing chip groups in adjacent columns and adjacent rows are provided in a staggered manner.

2. The LED light source module according to claim 1, wherein chips in each light-mixing chip group are sequentially provided along a length direction of each light-mixing chip group.

3. The LED light source module according to claim 2, wherein the length direction of each light-mixing chip group is perpendicular to an extension direction of the reference axis.

4. The LED light source module according to claim 1, wherein the plurality of the light-mixing chip groups are provided at intervals on the reference axis, and light-mixing chip groups provided on the reference axis are on-axis chip groups; and
types of chips in on-axis chip groups close to the first light-emitting region are different from that of the chips in the light-mixing chip groups provided in the first light-emitting region close to the reference axis.

5. The LED light source module according to claim 4, wherein types of chips in on-axis chip groups close to the second light-emitting region are different from those of the chips in the light-mixing chip groups provided in the second light-emitting region close to the reference axis.

6. The LED light source module according to claim 1, wherein the plurality of the light-mixing chip groups provided on the substrate form several light-mixing units; and
each light-mixing unit comprises four adjacent light-mixing chip groups, and centers of the four light-mixing chip groups are connected to form a rhombus.

7. The LED light source module according to claim 6, wherein a region surrounded by the four light-mixing chip groups in each light-mixing unit is an installation region, the LED light source module further comprises a plurality of warm-cool chip groups provided on the substrate, and each warm-cool chip group comprises a warm light chip and a cool light chip;
the plurality of warm-cool chip groups are provided in the installation region and outside each light-mixing chip group.

8. The LED light source module according to claim 7, wherein each warm-cool chip groups provided in the installation region comprises two warm light chips and two cool light chips, and the two warm light chips and the two cool light chips are provided in a staggered manner or adjacent manner.

9. The LED light source module according to claim 7 or 8, wherein the plurality of the warm-cool chip groups located in the installation region on the substrate form several warm-cool units, and each warm-cool unit comprises four adjacent warm-cool chip groups.

10. The LED light source module according to claim 9, wherein centers of the four warm-cool chip groups are connected to form a rhombus.

11. The LED light source module according to claim 7, wherein a diameter of the substrate perpendicular to the reference axis is a datum axis, and the plurality of light-mixing chip groups on both sides of the reference axis are symmetrically about the datum axis.

12. The LED light source module according to claim 11, wherein the plurality of the warm-cool chip groups are provided in an array on the substrate, and warm light chips and cool light chips in a plurality of warm-cool chip groups in each row are symmetrically and alternately provided on both sides of the datum axis.

13. The LED light source module according to claim 12, wherein two sides of the datum axis are a first side and a second side;
in the plurality of warm-cool chip groups in the same row, types of chips in warm-cool chip groups provided on the first side of the datum axis in the same row are the same, and types of chips in warm-cool chip groups provided on the second side of the datum axis in the same row are opposite to those in the warm-cool chip groups provided on the first side of the reference axis in the same row.

14. The LED light source module according to claim 11, wherein in an extension direction of the reference axis and a direction parallel to the reference axis, the plurality of warm-cool chip groups and the plurality of light-mixing chip groups on the substrate are alternately provided in sequence.

15. The LED light source module according to claim 14, wherein in the extension direction of the datum axis and the direction parallel to the datum axis, the plurality of warm-cool chip groups and the plurality of light-mixing chip groups on the substrate are alternately provided in sequence.
